# EUROPEAN PATENT SPECIFICATION

(11) **EP 0 853 136 B1**
(45) Date of publication and mention of the grant of the patent: **12.02.2003**
(21) Application number: 97929495.6
(22) Date of filing: 02.07.1997
(51) Int. Cl.: C23C 14/34

(54) **ALUMINUM OR ALUMINUM ALLOY SPUTTERING TARGET**
ALUMINIUM- ODER ALUMINIUMLEGIERUNGSTARGET
CIBLE DE PULVERISATION CATHODIQUE EN ALUMINIUM OU ALLIAGE D'ALUMINIUM

(30) Priority: 05.07.1996 JP 19415296
(43) Date of publication of application: 15.07.1998
(73) Proprietor: JAPAN ENERGY CORPORATION, Tokyo 105-0001 (JP)
(72) Inventor: FUKUYO, Hideaki, Japan Energy Corp., Isohara Plant, Kitaibaraki-shi, Ibaraki 319-15 (JP); SAWAMURA, Ichiroh, Japan Energy Corp.,, Kitaibaraki-shi, Ibaraki 319-15 (JP); OKABE, Takeo, Japan Energy Corp., Isohara Plant, Kitaibaraki-shi, Ibaraki 319-15 (JP); OHHASHI, Tateo, Japan Energy Corp., Isohara Plant, Kitaibaraki-shi, Ibaraki 319-15 (JP); NAGASAWA, Masaru, Japan Energy Corp.,, Kitaibaraki-shi, Ibaraki 319-15 (JP)
(74) Representative: Schwan, Gerhard, Dipl.-Ing.
(86) International application number: JP9702287
(87) International publication number: WO98001598

(56) References cited:
- JP-A- 6 280 005
- DATABASE WPI Section Ch, Week 9433 Derwent Publications Ltd., London, GB; Class L03, AN 94-267657 XP002094492 & JP 06 196441 A (NEC CORP), 15 July 1994

## Description

### TECHNICAL FIELD

The present invention relates to sputtering targets of high-purity aluminum or high-purity aluminum alloy and more particularly relates to high-purity aluminum or aluminum alloy sputtering targets which, when sputtered to form a thin film, do not involve much particle generation. Such a sputtering target is known from JP-A-6 280 005.

### BACKGROUND ART

Sputtering targets are usually in the form of circular discs which serve as sputtering sources when sputtering is used to form electrodes, gates, conductive patterns, elements, insulation films, protective films, etc. on substrates. As accelerated particles impinge against the surface of a target, atoms that constitute the target are partly released in an ambient spacing owing to momentum exchange and are deposited on an oppositely located substrate. Typical of sputtering targets in use include aluminum and aluminum alloy targets, refractory metal and alloy (W, Mo, Ti, Ta, Zr, Nb, etc. and their alloys such as W-Ti) targets, metallic silicides (MoSix, WSix, NiSix, etc.) targets, and platinum group metal targets.

An important one of these target groups is the group of aluminum and aluminum alloys for forming aluminum wirings. Also, thin films of aluminum are used as reflective surfaces of compact discs and magneto-optic discs.

The tendency toward larger scale integration of electronic circuits has reduced the width of their wiring to the sub-micrometer range. Consequently, the particles that generate upon forming a thin film by sputtering are presenting a major problem as a cause of disconnection or shorting of thecircuits. The term "particles" as used herein means the particulate matters that fly off from the target upon sputtering and deposit in clusters directly onto a thin film being formed on a substrate or once deposit and build up on surrounding walls and components and then come off onto the thin film. As for aluminum (alloy) targets, they too must cope with the advent of finer aluminum wiring and higher quality reflective surfaces of compact and magneto-optic discs. To meet the end, it is desired to decrease the number of particles that result from sputtering, specifically the number of particles 0.3 µ m or larger in diameter to 50 or fewer per square centimeter.

Under the circumstances, the present inventors have found that particles originate from inclusions in aluminum (alloy) targets and that the inclusions are mostly oxides. On the basis of the findings, we previously proposed aluminum or aluminum alloy sputtering targets characterized in that the number of inclusions 10 µ m or more in average diameter that appear on the sputter surface of a target is fewer than 40 per square centimeter and the oxygen content in the target is less than 15 ppm (Japanese Patent Application No. 7-192619).

As described in the above Patent Application No. 7-192619, a decrease in the oxygen content of an aluminum or aluminum alloy target makes it possible substantially to control the generation of particles. However, it has been pointed out that there still is a problem of sudden increase in the number of particles during the course of sputtering. Although the average number of particles during sputtering is at a satisfactorily low level, it can occur that the number of particles in one wafer lot or other, all of sudden, exceeds a controllable limit. This phenomenon of sudden particle generation is a factor that can lower the yield of an LSI fabrication process.

The present invention is aimed at providing high-purity aluminum or high-purity aluminum alloy sputtering targets specifically capable of controlling the sudden particle generation during film formation by sputtering.

### DISCLOSURE OF INVENTION

The present inventors have concentrated our efforts in solving the problems of the prior art and have primarily investigated about the form in which oxygen occurs in aluminum or aluminum alloy targets. The investigations have suggested a strong possibility of the presence as composite inclusions of alumina and carbon particles that apparently originate from the graphite crucible used in melting target materials.

The composite inclusions are rather roughly or scatteringly distributed and are not included in specimens usually sampled for oxygen analysis, being seldom counted in analytical values. Nevertheless they can cause particle generation during a sputtering process. It is presumed especially with low oxygen-content targets that the relatively rough distribution induces a sudden increase in the number of particles.

In addition to the findings as above, the present inventors have now revealed the possibility of using the number of "indication" in ultra-sonic flaw detection of a target material as a measure of the frequency of presence of graphite-alumina composite inclusions in an aluminum or aluminum alloy target.

On the basis of the foregoing, the present invention provides a sputtering target of high-purity aluminum or high-purity aluminum alloy wherein the oxygen content in the target is less than 5 ppm characterized in that in ultrasonic flaw detection from the target surface, the number of indication corresponding to flat bottom holes 0.5 mm or more in diameter is fewer than 0.014 per square centimeter.

### BRIEF EXPLANATION OF THE DRAWINGS

FIG. 1 is a graph showing changes in the numbers of particles with lots that used Target A (Comparative Example) and Target B (Example).

FIG. 2 is a graph showing changes in the numbers of particles with lots that used Target C (Comparative Example) and Target D (Example).

### BEST MODE FOR CARRYING OUT THE INVENTION

Particles upon sputtering are generated as inclusions in the target burst into tiny particulate matters. The tiny particulate matters fall back and deposit around pores left open by the burst. The deposit then comes off, too becoming a cause of particles. Since the inclusions that give birth to the particles consist mainly of oxides, the oxygen content in a target is limited to less than 5 ppm. In addition, the number of indication corresponding to flat bottom holes 0.5 mm or more in diameter is set to fewer than 0.014 per square centimeter so that the level of graphite-alumina composite inclusions in the target is lowered and the possibility of sudden particle generation is satisfactorily reduced.

The expression "high-purity aluminum" used as a material for sputtering targets according to the present invention means aluminum of 99.99% or greater purity. By "aluminum alloy" is meant a high-purity aluminum containing up to 10% by weight, in total, of one or two or more elements usually added to sputtering targets, such as Si, Cu, Ti, Ge, Cr, Ni, Mo, B, Zr, Nd, Ta.

As materials for the manufacture of sputtering targets according to the present invention, commercially available high-purity aluminum materials with or without the addition of the above-mentioned alloying elements may be used. In any case, the material chosen must have the least possible contents of impurities, such as radioactive elements or alkali metals, that can have adverse effects upon electronic devices and the like.

A target is usually fabricated by melting and casting a material, heat treating and working the cast piece to impart proper crystal structure, grain size, etc., and then machining and finishing the workpiece to final target dimensions in the form of a disc or the like. Adequate combination of plastic working, such as rolling and forging, with heat treatment permits optimum adjustments of the crystalline orientation and other qualities of the resulting target.

Inclusions for the most part come from the process steps of material melting and casting. They are predominantly oxides, the remainder being nitrides, carbides, hydrides, sulfides, silicides, etc. In view of this, crucibles, gates, molds, etc. used for target fabrication is made of reducing materials by preference. Also, it is important in casting molten aluminum or aluminum alloy to thoroughly remove oxides and other slags that come up to the surface of the melt. The melting and casting are carried out in a non-oxidizing atmosphere, preferably in a vacuum.

Particles upon sputtering are generated as inclusions in the target burst into tiny particulate matters. The tiny particulate matters fall back and deposit around pores left open by the burst. The deposit then comes off, too becoming a cause of particles. The inclusions that give birth to the particles consist mainly of oxides, and when an oxygen content in the target becomes more than 5 ppm, the particle generation is encouraged noticeably. Therefore, the oxygen content in a target is limited to less than 5 ppm.

It is also necessary to reduce the proportion of graphite-alumina composite inclusions that can cause sudden particle generation. These inclusions are rather roughly distributed and are not included in specimens usually sampled for oxygen analysis; they are rarely counted in analytical values. With this in view, a target material is subjected to ultrasonic flaw detection from its surface, and the number of indication corresponding to flat bottom holes 0.5 mm or more in diameter thus observed is used as a measure of the frequency of presence of the graphite-alumina composite inclusions.

The indication measurement in ultrasonic flaw detection can be made on the basis of the intensities of reflected echoes that vary with distances to indications, dimensions and configurations of the indications, etc. In general, the magnitude of an indication is estimated by comparing the intensity of its indication echo with a DGS chart of measurements with echoes reflected from flat bottom holes machined to varied depths and dimensions. Thus, a flat bottom hole diameter of 0.5 mm means the magnitude of an indication having an intensity equivalent to that of the echo reflected from a flat bottom hole having a diameter of 0.5 mm and as much depth. It is also known as an equivalent diameter.

When the number of indication corresponding to the flat bottom hole diameter of 0.5 mm or more is greater than 0.014 per square centimeter, the sudden increase in the number of particles becomes remarkable. Therefore, the number of indication corresponding to flat bottom hole diameter of 0.5 mm or more is set to fewer than 0.014/cm². This value corresponds to fewer than 10 in an ordinary high-purity aluminum or aluminum alloy sputtering target, or a target 300 mm in diameter and from 10 to 15 mm thick.

Thus, under the present invention, the average number of particles can be decreased while, at the same time, controlling sudden particle generation, so as to meet future requirements for aluminum (alloy) targets.

### EXAMPLES

### (Example 1)

Two different types of Al-0.5%Cu alloy targets (300 mm in diameter and 10 mm thick) were made. The oxygen contents in the targets were determined. Ultrasonic flaw detection of the targets was performed from above their surfaces. The conditions used for the detection were as follows:
Oscillator diameter : 9.5 mm
" area : 68 mm²
" shape : circular
Ultrasonic frequency: 5 - 10 MHz

The oxygen contents in the targets, and the numbers of indication corresponding to flat bottom holes 0.5 mm or more in diameter in ultrasonic flaw detection per unit area were as follows:

| | Oxygen content (ppm) | Number/cm² of indication corresponding to flat bottom hole diameter of 0.5 mm or more |
|---|---|---|
| Target A (Comp.Ex.) | 1 | 0.0453 |
| Target B (Example) | 2 | 0.0042 |

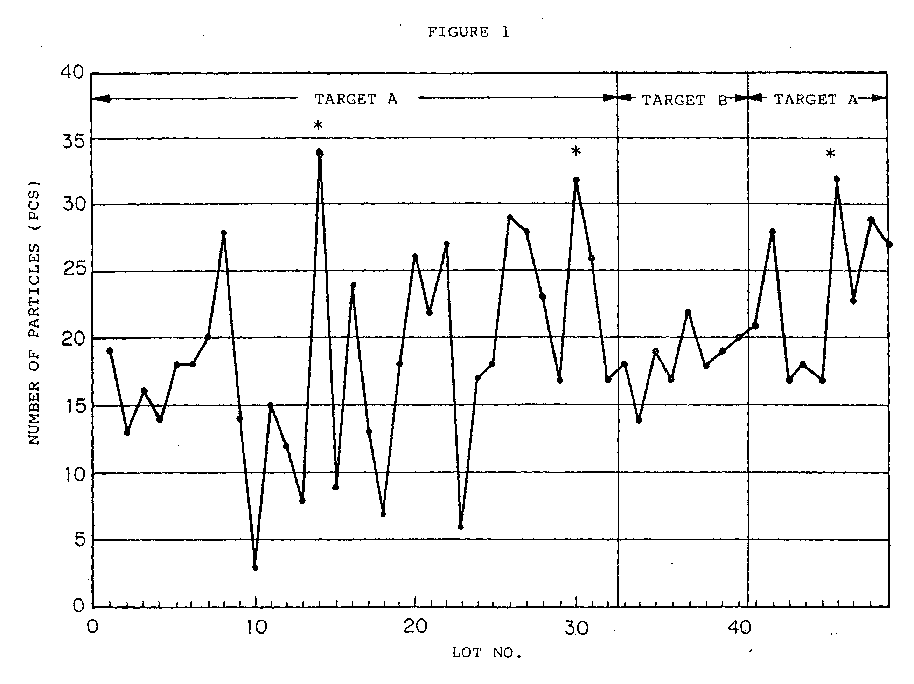

With these targets sputtering tests were carried out. Sputter films were formed on silicon wafers 8 in. in diameter and the number of particles 0.3 µm or larger in diameter were counted using a particle counter (Model No. 6420 manufactured by Tencor). Changes in numbers of particles in different lots are graphically represented in FIG. 1.

Lot Nos. 1 - 32 represent the results of sputtering with Target A, Lot Nos. 33 - 40 the results with Target B, and Lot Nos. 41 - 49 the results again with Target A.

When Target A was used, sudden increases in the number of particles (indicated by asterisks in FIG. 1) were observed. With Target B, stability was maintained with no such peak.

### (Example 2)

In the same way as in Example 1, two different types of Al-0.5%Cu alloy targets (300 mm in diameter and 10 mm thick) were made. The oxygen contents in the targets were determined, and ultrasonic flaw detection was performed from above their surfaces.

The oxygen contents in the targets, and the numbers of indication corresponding to flat bottom holes 0.5 mm or more in diameter in ultra- sonic flaw detection per unit area were as follows:

| | Oxygen content (ppm) | Number/cm² of indication corresponding to flat bottom hole diameter of 0.5 mm or more |
|---|---|---|
| Target C (Comp.Ex.) | 0.5 | 0.0325 |
| Target D (Example) | 0.5 | 0.0127 |

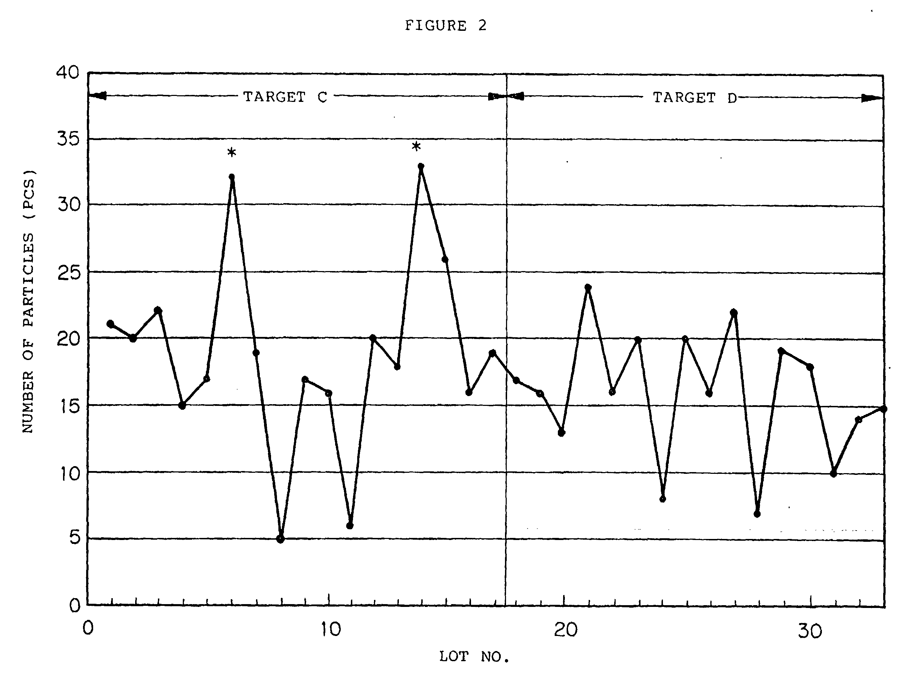

Using these targets, sputtering tests were carried out. Sputter films were formed on silicon wafers 8 in. in diameter and the number of particles 0.3 µm or larger in diameter were counted with a particle counter (Model No. 6420 manufactured by Tencor). Changes in numbers of particles in different lots are shown in FIG. 2.

Lot Nos. 1 - 17 represent the results of sputtering with Target C, and Lot Nos. 18 - 33 the results with Target D.

When Target C was used, sudden increases in the number of particles (indicated by asterisks in FIG. 2) beyond a controllable upper limit (30 in this case) were observed. On the other hand, with Target D, stability was maintained with no such increase.

### INDUSTRIAL APPLICABILITY

The high-purity aluminum or high-purity aluminum alloy sputtering target according to the present invention makes it possible to reduce the occurrence of sudden particle generation during the course of sputtering.

## Claims

1. A sputtering target of high-purity aluminum or high-purity aluminum alloy wherein the oxygen content in the target is less than 5 ppm, **characterized in that** in ultrasonic flaw detection from the target surface, the number of indication corresponding to flat bottom holes 0.5 mm or more in diameter is fewer than 0.014 per square centimeter.

## Patentansprüche

1. Sputtertarget aus hochreinem Aluminium oder hochreiner Aluminiumlegierung, wobei der Sauerstoffgehalt in dem Target unter 5 ppm liegt, **dadurch gekennzeichnet, dass** bei einer Ultraschall-Defektoskopie der Targetoberfläche die Anzeigezahl, die Löchern mit flachem Boden und einem Durchmesser von 0,5 mm oder größer entspricht, weniger als 0,014 pro Quadratzentimeter beträgt.

## Revendications

1. Source de pulvérisation cathodique en aluminium à haut degré de pureté ou en un alliage d'aluminium à haut degré de pureté, dans laquelle la teneur en oxygène de la source est inférieure à 5 ppm, **caractérisée en ce que**, lors de la détection de défauts aux ultrasons effectuée au-dessus de la surface de la source, le nombre d'indications correspondant à des trous à fond plat d'un diamètre de 0,5 mm ou plus est inférieur à 0,014 par centimètre carré.
